# EUROPÄISCHE PATENTANMELDUNG

(11) **EP 2 148 209 A2**
(43) Veröffentlichungstag der Anmeldung: **27.01.2010**
(21) Anmeldenummer: 09008436.9
(22) Anmeldetag: 29.06.2009
(51) Int. Cl.: G01R 1/073

(54) **Elektrische Prüfeinrichtung für die Prüfung eines elektrischen Prüflings sowie elektrisches Prüfverfahren**

(30) Priorität: 26.07.2008 DE 102008034918
(71) Anmelder: Feinmetall GmbH, 71083 Herrenberg (DE)
(72) Erfinder: Böhm, Gunther, 71154 Nufringen (DE); Kopilas, Bezislav, 75382 Althengstett (DE); Ehrler, Sylvia, 71034 Böblingen (DE); Holocher, Michael, 72108 Rottenburg (DE)
(74) Vertreter: Grosse, Rainer

(57) **Zusammenfassung**

Die Erfindung betrifft eine elektrische Prüfeinrichtung für die Prüfung eines elektrischen Prüflings, mit einem Leitersubstrat, das über einen Kontaktabstandstransformer mit einem Prüfkopf elektrisch verbunden ist, wobei das Leitersubstrat mit einer ersten Versteifungseinrichtung mechanisch verbunden und dadurch versteift ist. Es ist vorgesehen, dass mindestens ein das Leitersubstrat (12) durchgreifender Abstandshalter (30) mit dem Kontaktabstandstransformer (7) mechanisch verbunden ist und an der ersten Versteifungseinrichtung (26) über Neigungseinstellmittel (34) gehalten ist.

## Beschreibung

Die Erfindung betrifft eine elektrische Prüfeinrichtung für die Prüfung eines elektrischen Prüflings, mit einem Leitersubstrat, das über einen Kontaktabstandstransformer mit einem Prüfkopf elektrisch verbunden ist, wobei das Leitersubstrat mit einer ersten Versteifungseinrichtung mechanisch verbunden und dadurch versteift ist.

Eine elektrische Prüfeinrichtung der eingangs genannten Art ist bekannt. Sie dient dazu, einen elektrischen Prüfling, beispielsweise einen Wafer, elektrisch zu kontaktieren. Hierbei handelt es sich um eine Berührungskontaktierung, durch die elektrische Stromkreise zu einer Testeinrichtung geschaltet werden, die den Prüfling auf elektrische Funktionsfähigkeit prüft. Auf diese Art und Weise können funktionsfähige Prüflinge von nicht funktionsfähigen Prüflingen unterschieden werden. Die bekannte elektrische Prüfeinrichtung weist ein Leitersubstrat auf, das über einen Kontaktabstandstransformer mit einem Prüfkopf elektrisch verbunden ist. Kontaktnadeln des Prüfkopfs stehen mit dem Kontaktabstandstransformer elektrisch in Verbindung und dienen zur Kontaktierung des Prüflings. Das Leitersubstrat ist mit der bereits erwähnten Testeinrichtung elektrisch verbunden. Da die Kontaktabstände des Prüflings durch eine zunehmende hohe Integrationsdichte äußerst klein sind, ist zur Erhöhung der testbaren Verdrahtungsdichte zwischen dem Kontaktkopf und dem Leitersubstrat der Kontaktabstandstransformer vorgesehen, der die kleinen Kontaktabstände der Kontaktnadeln des Prüfkopfs auf größere Kontaktabstände transferiert, wobei die größeren Kontaktabstände mit gleichgroßen Kontaktabständen des Leitersubstrats korrelieren und das Leitersubstrat vorzugsweise eine weitere Kontaktabstandsvergrößerung realisiert, wobei letztlich die diesen größeren Kontaktabstand aufweisenden Kontakte des Leitersubstrats mittels geeigneter Kabelverbindungen oder dergleichen mit der Testeinrichtung in Verbindung stehen. Da sich insofern zwischen dem Leitersubstrat und dem Kontaktkopf mindestens eine für die elektrische Verbindung notwendige Baugruppe befindet, ist eine für eine Kontaktgabe hinreichende Ausrichtung der beteiligten Bauteile nicht immer gegeben, sodass die Funktionsfähigkeit einer derartigen elektrischen Prüfeinrichtung in Frage steht. In diesem Zusammenhang ist zu erwähnen, dass der Kontaktkopf zum Kontaktabstandstransformer und der Kontaktabstandstransformer zu dem Leitersubstrat jeweils nur im elektrischen Berührungskontakt steht.

Der Erfindung liegt daher die Aufgabe zugrunde, eine elektrische Prüfeinrichtung für die Prüfung eines elektrischen Prüflings bereitzustellen, die eine hohe Kontaktsicherheit und Funktionssicherheit besitzt, sodass die Prüfung eines elektrischen Prüflings fehlerfrei durchgeführt werden kann.

Diese Aufgabe wird erfindungsgemäß unter Einbeziehung der eingangs genannten Merkmale dadurch gelöst, dass mindestens ein das Leitersubstrat durchgreifender Abstandshalter mit dem Kontaktabstandstransformer mechanisch verbunden ist und an der ersten Versteifungseinrichtung mit Neigungseinstellmittel gehalten ist. Die auf das Leitersubstrat wirkenden Berührungskontaktkräfte können bei einer hohen Prüfkontaktdichte in ihrer Summe große Werte annehmen. Um eine mechanische Verformung durch diese Kontaktkräfte bei dem Leitersubstrat zu vermeiden, ist letzterem die erste Versteifungseinrichtung zugeordnet. Für eine einwandfreie elektrische Berührungskontaktierung zwischen Kontaktkopf und Leitersubstrat - unter Zwischenschaltung des Kontaktabstandstransformers und gegebenenfalls weiterer elektrischer Verbindungsmittel (Konnektoren) - sieht die Erfindung vor, dass der Kontaktabstandstransformer (Spacetransformer) relativ zum Leitersubstrat neigungsverstellbar angeordnet ist. Hierzu sind die Neigungseinstellmittel vorgesehen, die über mindestens einen das Leitersubstrat durchgreifenden, mit dem Kontaktabstandstransformer mechanisch verbundenen Abstandshalter die Neigungsverstellung vornehmen. Insbesondere kann ein Neigeelement vorgesehen sein, das über den mindestens einen, das Leitersubstrat durchgreifenden Abstandshalter mit dem Kontaktabstandstransformer mechanisch verbunden ist und neigungsverstellbar an der ersten Versteifungseinrichtung über die Neigungseinstellmittel gehalten ist. Versteifungseinrichtung und Neigeelement bilden daher eine in sich durch den Abstandshalter bewirkte starre Struktur, wobei sich jedoch zwischen diesen beiden Teilen das Leitersubstrat befindet. Da dieses jedoch mittels des mindestens einen Abstandshalters durchgriffen wird, führt eine Neigungsbewegung der Neigeplatte über den Abstandshalter zu einer entsprechenden Bewegung des Kontaktabstandstransformers, ohne dass dabei das Leitersubstrat seine Position ändert. Der mindestens eine Abstandshalter durchsetzt vorzugsweise berührungsfrei mindestens eine Öffnung der Leiterplatte. Um das Neigeelement relativ zum Leitersubstrat neigen zu können, ist es über Neigungseinstellmittel an der ersten Versteifungseinrichtung gehalten, die wiederum unverlagerbar mit dem Leitersubstrat in Verbindung steht. Wird also das Neigeelement relativ zur ersten Versteifungseinrichtung geneigt, so führt dies zu einer entsprechenden Neigungsbewegung des Kontaktabstandstransformers (auch Spacetransformer genannt) relativ zum Leitersubstrat. Unabhängig davon, ob eine Ausgestaltung der Erfindung ohne oder mit Neigeelement vorliegt, wird eine Referenzfläche am Kontaktabstandstransformer relativ zu einer Referenzfläche an dem Leitersubstrat neigungsjustiert. Hierdurch lassen sich Kontaktabstandstransformer und Leitersubstrat in gewünschter Weise relativ zueinander ausrichten, wodurch einerseits eine gute Kontaktgabe der Kontaktnadeln des Prüfkopfs zum elektrischen Prüfling (Wafer) realisiert werden kann und andererseits auch für eine gute Kontaktgabe - gegebenenfalls unter Zwischenschaltung von elektrischen Verbindungsmittel (Konnektoren) - zu dem Leitersubstrat gesorgt wird.

Nach einer Weiterbildung der Erfindung ist vorgesehen, dass der Abstandshalter die erste Versteifungseinrichtung durchgreift. Dadurch reicht der Abstandshalter bis auf die dem Leitersubstrat abgewandte Seite der ersten Versteifungseinrichtung, sodass dort die Neigungseinstellmittel vorgesehen sein können.

Nach einer Weiterbildung der Erfindung ist vorgesehen, dass das Leitersubstrat erste Kontaktflächen aufweist, die über Kontaktmittel mit Gegenkontaktflächen des Kontaktabstandstransformers verbunden sind. Bei den erwähnten Kontaktmitteln handelt es sich um die bereits erwähnten elektrischen Verbindungsmittel, die auch Konnektoren genannt werden. Die Kontaktmittel stehen mit den ersten Kontaktflächen des Leitersubstrats in Berührungskontakt und auch ebenso in Berührungskontakt mit den Gegenkontaktflächen des Kontaktabstandstransformers.

Es ist vorteilhaft, wenn die Kontaktmittel einen durch Neigungseinstellung bewirkten Winkelversatz zwischen Leitersubstrat und Kontaktabstandstransformer ausgleichen. Demzufolge sind die Kontaktmittel derart flexibel gestaltet, dass bei einer Neigungsverstellung zwischen der Referenzfläche des Leitersubstrats und der Referenzfläche des Kontaktabstandstransformers die Kontaktmittel den Berührungskontakt zu den ersten Kontaktflächen des Leitersubstrats und den Gegenkontaktflächen des Kontaktabstandstransformers aufrechterhalten.

Eine Weiterbildung der Erfindung sieht vor, dass der Kontaktabstandstransformer zweite Kontaktflächen aufweist, die mit Kontaktstiften/Kontaktnadeln, insbesondere Knicknadeln, des Prüfkopfs in elektrischem Kontakt stehen. Der Prüfkopf weist vorzugsweise mit Abstand zueinander liegende Führungsplatten auf, die Führungsöffnungen besitzen, welche von den insbesondere als Knicknadeln ausgebildeten Kontaktstiften durchsetzt werden. Die einen Enden der Knicknadeln treten in Berührungskontakt mit den zweiten Kontaktflächen des Kontaktabstandstransformers und die anderen Enden der Knicknadeln dienen dem Berührungskontakt von elektrischen Kontakten des Prüflings. Demzufolge werden bei einer elektrischen Prüfung des Prüflings Prüfeinrichtung und Prüfling aufeinanderzubewegt, um die Berührungskontaktierung des Prüflings zu bewirken. Entweder bewegen sich Prüfeinrichtung und Prüfling oder nur eine dieser Baugruppen. Die Bewegung erfolgt in Längserstreckung der Kontaktstifte des Kontaktkopfs. Da vorzugsweise Knicknadeln als Kontaktstifte verwendet werden, weisen diese hinsichtlich ihrer Längserstreckung durch Ausknicken eine Längenanpassung auf.

Eine Weiterbildung der Erfindung sieht vor, dass am Kontaktabstandstransformer Kontaktelemente zur elektrischen Berührungskontaktierung des Prüflings fest angeordnet sind. Im Gegensatz zu der vorstehend erwähnten Ausgestaltung, bei der der Kontaktabstandstransformer zweite Kontaktflächen aufweist, die in Berührungskontaktierung mit Kontaktstiften treten, die wiederum mit dem Prüfling in elektrischen Berührungskontakt gebracht werden, ist demzufolge vorgesehen, dass die Kontaktelemente, die der Kontaktierung des Prüflings dienen, fest an dem Kontaktabstandstransformer angeordnet sind. Ein vorzugsweise abnehmbarer Prüfkopf liegt dann nicht vor.

Es ist ferner vorteilhaft, wenn bei einer alternativen Ausführungsform die Kontaktmittel direkt und fest am Kontaktabstandstransformer angeordnet sind. Demzufolge sind die Kontaktmittel daher dem Kontaktabstandstransformer direkt zugeordnet und an diesem gehalten. Alternativ ist es möglich, dass die Kontaktmittel Elemente einer eigenen Baugruppe sind, die zwischen dem Leitersubstrat und dem Kontaktabstandstransformer angeordnet ist.

Eine Weiterbildung der Erfindung sieht eine zweite Versteifungseinrichtung vor, wobei die erste Versteifungseinrichtung auf der einen Seite des Leitersubstrats und die zweite Versteifungseinrichtung auf der anderen Seite des Leitersubstrats angeordnet ist. Demzufolge wird das Leitersubstrat beidseitig versteift, indem beide Versteifungseinrichtungen mit dem Leitersubstrat mechanisch verbunden sind. Insbesondere kann vorgesehen sein, dass die beiden Versteifungseinrichtungen mittels entsprechender Spannmittel aufeinanderzugespannt sind und hierdurch das Leitersubstrat insbesondere klemmend und abstützend zwischen sich aufnehmen.

Eine bevorzugte Ausführungsform der Erfindung sieht vorzugsweise vor, dass der zweiten Versteifungseinrichtung der Kontaktabstandstransformer zugeordnet ist. Insbesondere weist die zweite Versteifungseinrichtung einen Aufnahmedurchbruch auf, in dem der Kontaktabstandstransformer berührungsfrei zumindest teilweise aufgenommen ist. Diese Anordnung ermöglicht die unmittelbare Zuordnung der zweiten Versteifungseinrichtung zum Leitersubstrat und bewirkt ferner durch den Aufnahmedurchbruch eine nahe Zuordnung des Kontaktabstandstransformers zum Leitersubstrat. Um eine durch das Neigeelement veranlasste Neigungsbewegung des Kontaktabstandstransformers zu bewirken, darf dieser nicht gegen die zweite Versteifungseinrichtung anliegen. Durch die berührungsfreie Aufnahme des Kontaktabstandstransformers in dem Aufnahmedurchbruch der zweiten Versteifungseinrichtung ist eine Neigebewegung daher nicht behindert.

Für die erwähnte Neigungsverstellung sind vorzugsweise Neigungseinstellmittel in Form von Gewindeschrauben vorgesehen. Die Gewindeschrauben können als Einstellschrauben und/oder als Feststellschrauben ausgebildet sein. Die Einstellschrauben dienen dazu, eine entsprechende Winkellage des Neigungselements zur ersten Versteifungseinrichtung herbeizuführen und die Feststellschrauben dienen dazu, diese Winkellage zu fixieren. Hierzu sind die Einstellschrauben in das Neigeelement einstellbar eingeschraubt, wobei sie sich mit ihren einen Enden an der ersten Versteifungseinrichtung abstützen. Die Feststellschrauben sind in die erste Versteifungseinrichtung eingeschraubt und liegen mit ihren Köpfen spannend an dem Neigeelement an. Die Neigungsverstellung kann auch auf andere Weise erfolgen. Insbesondere können hierzu Schrauben vorgesehen sein, denen ein Fühlerlehrenband (Spezialfolie, die in sehr feinen Dickenabstufungen erhältlich ist) untergelegt ist. Die Spezialfolie besteht vorzugsweise aus Stahl oder Neusilber.

Das Neigeelement ist bevorzugt als Neigeplatte ausgebildet. Das Leitersubstrat ist insbesondere als Leiterplatte ausgebildet. Die erste und/oder die zweite Versteifungseinrichtung ist/sind vorzugsweise plattenförmig ausgebildet.

Nach einer Weiterbildung der Erfindung ist vorgesehen, dass der Abstandshalter eine Distanzhülse aufweist. Diese ist mit ihrem einen Ende am Kontaktabstandstransformer und mit ihrem anderen Ende an dem Neigeelement befestigt.

Bevorzugt sind Ausrichtmittel vorhanden, die das Leitersubstrat zu dem Kontaktabstandstranformer seitwärts ausrichten, um auf diese Art und Weise die ersten Kontaktflächen des Leitersubstrats relativ zu den Gegenkontaktflächen des Kontaktabstandstransformers zu positionieren, so dass die dazwischen liegenden Kontaktmittel (Konnektoren) jeweils einander zugeordnete erste Kontaktflächen mit zugeordneten Gegenkontaktflächen elektrisch einwandfrei verbinden können.

Nach einer Weiterbildung der Erfindung kann vorgesehen sein, dass die Neigungseinstellmittel an dem Abstandshalter angeordnet sind. Diese wirken mit der ersten Versteifungseinrichtung zusammen.

Ferner sind bevorzugt mehrere Abstandshalter vorgesehen, die mit Abstand zueinander angeordnet sind.

Die Erfindung betrifft ferner ein Verfahren für die elektrische Prüfung eines elektrischen Prüflings, insbesondere mit Verwendung der vorstehend erläuterten Prüfeinrichtung, mit einem Leitersubstrat, das über einen Kontaktabstandstransformer mit einem Prüfkopf elektrisch verbunden wird, wobei das Leitersubstrat mit einer ersten Versteifungseinrichtung mechanisch verbunden und dadurch versteift wird, und wobei mindestens ein das Leitersubstrat durchgreifender Abstandshalter mit dem Kontaktabstandstransformer mechanisch verbunden wird und an der ersten Versteifungseinrichtung über Neigungseinstellmittel gehalten wird.

Weitere vorteilhafte Ausgestaltungen des Verfahrens ergeben sich aus den Ansprüchen.

Die Zeichnungen veranschaulichen die Erfindung anhand eines Ausführungsbeispiels, und zwar zeigt:
- Figur 1: eine schematische Längsschnittansicht durch eine elektrische Prüfeinrichtung für die Prüfung eines elekt- rischen Prüflings, wobei die Prüfeinrichtung jedoch nicht komplett mit allen Bauteilen dargestellt ist,
- Figur 2: eine perspektivische Längsschnittansicht durch die Prüfeinrichtung der Figur 1, ohne Darstellung eines Kontaktkopfs,
- Figur 3: eine perspektivische Ansicht auf einen Kontakt- abstandstransformer und ein Neigeelement der Prüfein- richtung,
- Figur 4: eine perspektivische Ansicht auf die Anordnung der Figur 3, jedoch aus einem anderen Blickwinkel,
- Figur 5: eine Längsschnittansicht eines Bereichs der elektri- schen Prüfeinrichtung ohne Darstellung des Kontakt- kopfs,
- Figur 6: einen perspektivischen Längsschnitt durch einen Be- reich einer elektrischen Prüfeinrichtung nach einem weiteren Ausführungsbeispiel,
- Figur 7: eine Detailansicht der Prüfeinrichtung der Figur 6 und
- Figur 8: eine weitere Detailansicht der Prüfeinrichtung der Figur 6.

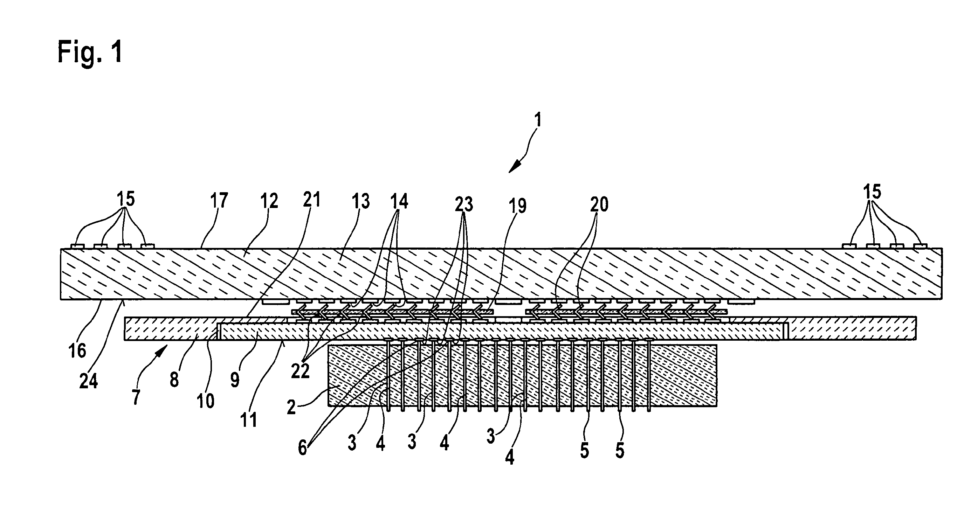

Die Figur 1 zeigt eine Prüfeinrichtung 1, von der jedoch nicht alle Bauteile dargestellt sind. Die Prüfeinrichtung 1 weist einen Kontaktkopf 2 (auch Prüfkopf 2 genannt) auf, der in Führungsbohrungen 3 verschieblich gelagerte Kontaktstifte 4 besitzt, die bevorzugt als Knicknadeln ausgebildet sind. Die Kontaktstifte 4 besitzen freie Enden 5, welche mit Kontakten eines nicht dargestellten elektrischen Prüflings berührungskontaktiert werden können. Hierzu wird die Prüfeinrichtung 1 auf den Prüfling abgesenkt oder es wird der Prüfling an die Prüfeinrichtung 1 herangeführt oder beide Teile bewegen sich aufeinander zu. Die anderen Enden 6 der Kontaktstifte 4 stehen in Berührungskontakt zu einem Kontaktabstandstransformer 7, der einen Träger 8 und eine elektrische Kontaktabstandsumsetzschaltung 9 aufweist. Der Träger 8 ist vorzugsweise als Metallträger ausgebildet. Die Kontaktabstandsumsetzschaltung 9 ist fest mit dem Keramikträger 8 verbunden. Der Träger 8 besitzt eine Aufnahme 10, in der die Kontaktabstandsumsetzschaltung 9 versenkt aufgenommen ist. Der Kontaktabstandstransformer 7 besitzt auf seiner dem Kontaktkopf 2 zugewandten Seite eine Referenzfläche 11. Mit geringfügigem Abstand zum Kontaktabstandstransformer 7 ist ein Leitersubstrat 12, insbesondere in Form einer Leiterplatte 13 angeordnet. Die Leiterplatte 13 weist erste Kontaktflächen 14 auf, die mit Flächenkontakten 15 elektrisch in Verbindung stehen, wobei die ersten Kontaktflächen 14 auf der einen Seite 16 und die Flächenkontakte 15 auf der anderen Seite 17 des Leitersubstrats 12 angeordnet sind. Zwischen dem Kontaktabstandstransformer 7 und dem Leitersubstrat 12 sind elektrische Kontaktmittel 18 angeordnet, die an einem Isolierträger 19 elektrische Kontakte 20 aufweisen. Auf seiner dem Leitersubstrat 12 zugekehrten Seite 21 besitzt der Kontaktabstandstransformer 7 im Bereich seiner Kontaktabstandsumsetzschaltung 9 Gegenkontaktflächen 22, die über die Kontakte 20 mit den ersten Kontaktflächen 14 elektrisch verbunden sind. Der Kontaktabstandstransformer 7 weist im Bereich seiner Kontaktabstandsumsetzschaltung 9 zweite Kontaktflächen 23 auf, die mit den Gegenkontaktflächen 22 elektrisch verbunden sind. Die Enden 6 der Kontaktstifte 4 liegen im Berührungskontakt gegen die zweiten Kontaktflächen 23 an.

Vom nicht dargestellten Prüfling her gesehen ergeben sich folgende elektrischen Pfade der Prüfeinrichtung 1, wobei hier der Einfachheit halber nur einer dieser Pfade erläutert werden soll. Die anderen Pfade entsprechen dem erläuterten Pfad. Ein am Prüfling vorhandener Kontakt tritt bei der Prüfung des elektrischen Prüflings in Berührungskontakt mit dem Ende 5 des Kontaktstifts 4, dessen anderes Ende 6 in Berührungskontakt steht zu einer der zweiten Kontaktflächen 23, die innerhalb der Kontaktabstandsumsetzschaltung 9 verdrahtet ist mit einer der Gegenkontaktflächen 22, gegen die im Berührungskontakt ein Ende eines der Kontakte 20 steht, wobei das andere Ende des Kontakts 20 in Berührungskontakt gegen eine der ersten Kontaktflächen 14 anliegt, die innerhalb des Leitersubstrats 12 verdrahtet ist mit einer der Flächenkontakte 15. Der Flächenkontakt 15 ist über eine nicht dargestellte elektrische Leitung mit einer Testeinrichtung verbunden. Insgesamt wird deutlich, dass zwischen Testeinrichtung und Prüfling elektrische Prüfstromwege hergestellt werden können, um diesen auf einwandfreie elektrische Funktion zu prüfen. Der Kontaktabstand der Kontaktstifte 4 entspricht der Kontaktdichte des Prüflings. Der Kontaktabstandstransformer 7 dient dazu, diesen engen Kontaktabstand in einen weniger engen Kontaktabstand umzuwandeln. Dies ist der Figur 1 zu ersehen, da dort die Gegenkontaktflächen 22 einen größeren Abstand zueinander aufweisen als die zweiten Kontaktflächen 23. Mittels des Leitersubstrats 12 wird der Kontaktabstand der ersten Kontaktflächen 14 nochmals vergrößert, indem der Kontaktabstand der Flächenkontakte 15 größer ist, als der der ersten Kontaktflächen 14.

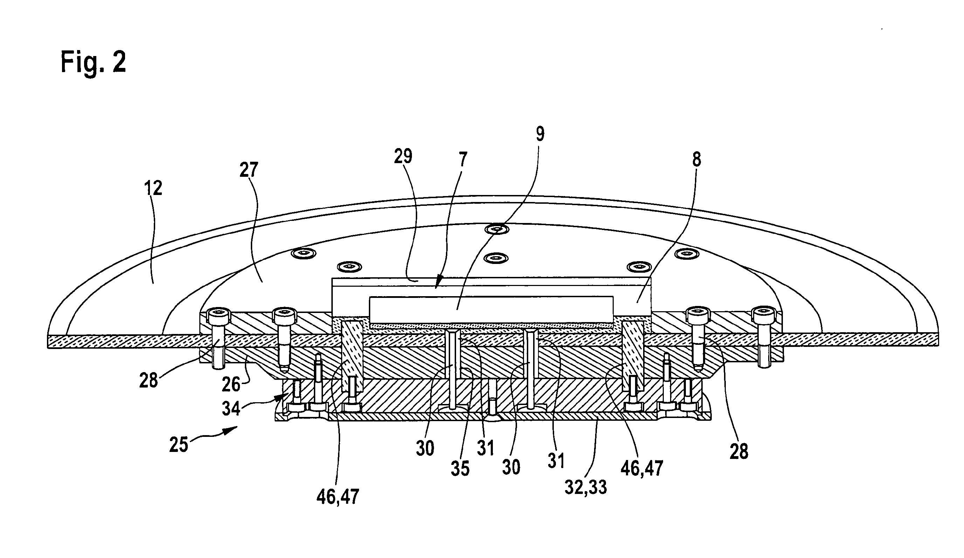

Um die Referenzfläche 11 des Kontaktabstandstransformers 7 hinsichtlich ihrer Neigung gegenüber einer Referenzfläche 24 des Leitersubstrats 12 ausrichten zu können, ist eine Neigungseinrichtung 25 (Figur 2) vorgesehen. Die Referenzfläche 24 des Leitersubstrats 12 entspricht der Seite 16 dieses Bauteils.

In der Figur 2 ist die Anordnung der Figur 1 nochmals dargestellt, wobei jedoch der Kontaktkopf 2 und die Kontaktmittel 18 nicht eingezeichnet sind und der in der Figur 1 nach unten weisende Bereich der Prüfeinrichtung 1 nunmehr in der Figur 2 nach oben weist. Aus der Figur 2 ist ferner ersichtlich, dass dem Leitersubstrat 12 eine erste Versteifungseinrichtung 26 und eine zweite Versteifungseinrichtung 27 zugeordnet sind. Die erste Versteifungseinrichtung 26 befindet sich in Anlage an die Seite 17 des Leitersubstrats 12. Die zweite Versteifungseinrichtung 27 ist auf der Seite 16 des Leitersubstrats 12 angeordnet. Beide Versteifungseinrichtungen 26 und 27 werden über Spannmittel 28 miteinander verspannt, sodass sie klemmend das Leitersubstrat 12 zwischen sich aufnehmen und insofern versteifen.

Die zweite Versteifungseinrichtung 27 besitzt einen Aufnahmedurchbruch 29, in dem der Kontaktabstandstransformer 7 berührungsfrei aufgenommen ist. Er wird dort gehalten von mehreren Abstandshaltern 30, die Öffnungen 31 des Leitersubstrats 12 berührungsfrei durchsetzen und bis zu einem Neigeelement 32 führen. Das Neigeelement 32 ist insbesondere als Neigeplatte 33 ausgebildet. Das Neigeelment 32 steht über Neigungseinstellmittel 34 mit der ersten Versteifungseinrichtung 26 neigbar in Verbindung. Die Abstandshalter 30 durchsetzen berührungsfrei Öffnungen 35 der ersten Versteifungseinrichtung 26.

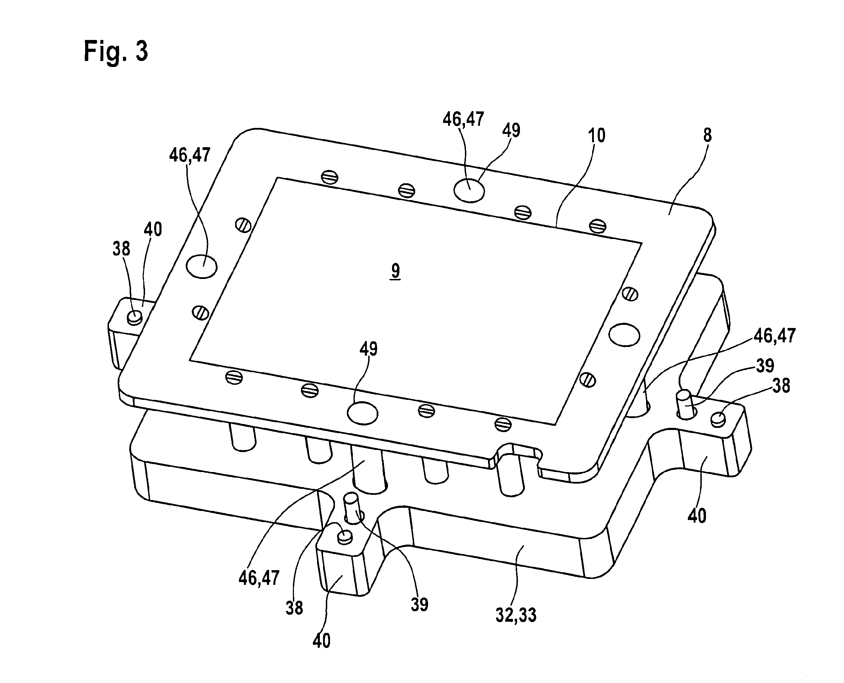

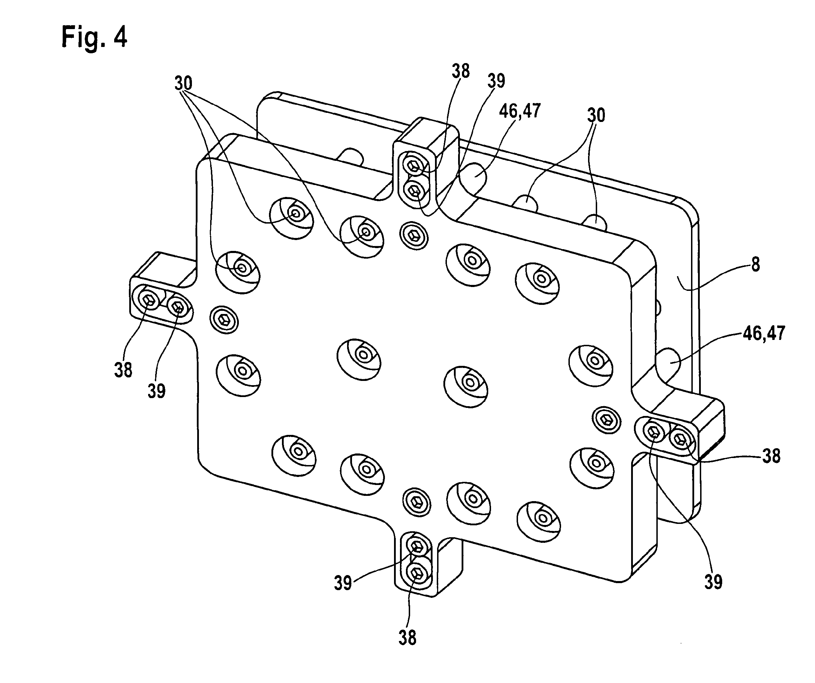

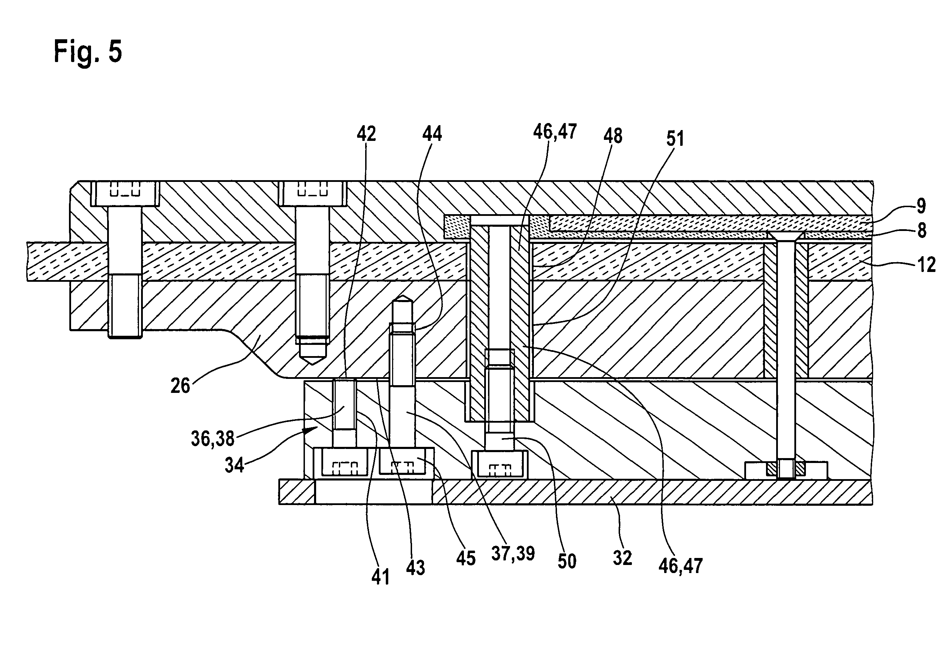

Aus der Figur 5 ist der Aufbau der Neigungseinstellmittel 34 deutlich erkennbar. Die Neigungseinstellmittel 34 weisen Gewindeschrauben 36 und 37 auf, wobei die Gewindeschrauben 36 als Einstellschrauben 38 und die Gewindeschrauben 37 als Feststellschrauben 39 ausgebildet sind. Aus den Figuren 3 und 4 ist ersichtlich, dass das Neigeelement 32 mehrere mit Abstand zueinander angeordnete Einstellschrauben 38 und Feststellschrauben 39 aufweist, wobei jeweils eine Einstellschraube 38 und eine Feststellschraube 39 benachbart zueinander liegen. Im Ausführungsbeispiel der Figuren 3 und 4 ist das Neigeelement 32 als rechteckige Neigeplatte 33 ausgebildet, die im Bereich ihrer vier Seiten jeweils Vorsprünge 40 aufweist, denen jeweils eine Einstellschraube 38 und eine Feststellschraube 39 zugeordnet sind.

Die Anordnung ist nun so getroffen, dass - gemäß Figur 5 - jede der Einstellschrauben 38 mit ihrem Gewinde in eine Gewindebohrung 41 des Neigeelements 32 einstellbar eingeschraubt ist und sich mit ihrem einen Ende 42 an einer Außenseite 43 der ersten Versteifungseinrichtung 26 abstützt. Die zugeordnete Feststellschraube 39 ist in eine Gewindebohrung 44 der ersten Versteifungseinrichtung 26 eingeschraubt und liegt mit ihrem Kopf 45 spannend an dem Neigeelement 32 an. Die Feststellschraube 39 zieht daher das Neigeelement 32 in Richtung auf die erste Versteifungseinrichtung 26, so dass das Ende 42 der Einstellschraube 38 gegen die Außenseite 43 der ersten Versteifungseinrichtung 26 gepresst wird. Aus alledem wird deutlich, dass in Abhängigkeit von der Herausraglänge, also der Einschraubtiefe, der Einstellschrauben 38 die Abstandsposition des Neigeelements 32 zur ersten Versteifungseinrichtung 26 eingestellt werden kann. Da mehrere Paare von Einstellschrauben 38 und Feststellschrauben 39 vorgesehen sind, lässt sich die Position des Neigeelements 32 hinsichtlich seiner Neigung relativ zur ersten Versteifungseinrichtung 26 mittels der Neigungseinstellmittel 34 auf eine gewünschte Position einstellen. Da das Neigeelement 32 über die Abstandshalter 30 starr mit dem Kontaktabstandstransformer 7 gekuppelt ist, wird bei einer Neigungsverstellung des Neigeelements 32 sich in gleicher Weise die Position, und insbesondere auch die Neigungsposition des Kontaktabstandstransformers 7 verändern. Daraus ergibt sich, dass mittels der Neigungseinstellmittel 34 die Referenzfläche 11 des Kontaktabstandstransformers 7 relativ zur Referenzfläche 24 des Leitersubstrats 12 einstellbar ist.

Aus den Figuren 2 bis 5 sind ferner Ausrichtmittel 46 in Form sogenannter Alignment-Pins 47 ersichtlich, die der seitlichen Ausrichtung von Leitersubstrat 12 zum Kontaktabstandstransformer 7 dienen. Diese Ausrichtung wird auch Registrierung genannt und sorgt dafür, dass die ersten Kontaktflächen 14 in gewünschter Weise zu den Gegenkontaktflächen 22 in Richtung der Erstreckung der Ebene der Leiterplatte 13 ausgerichtet werden. Hierzu durchgreifen die stabförmigen, vorzugsweise im Querschnitt unrunden, insbesondere im Querschnitt stadionförmigen Ausrichtmittel 46, entsprechende Führungsöffnungen 48 im Leitersubstrat 12 und Führungsöffnungen 49 im Kontaktabstandstransformer 7. Die Ausrichtmittel 46 sind mittels Befestigungsschrauben 50 am Neigeelement 32 fixiert. Diese Führungsöffnungen 48 und 49 bilden Passungen für die stiftförmigen Ausrichtmittel 46. Die Ausrichtmittel 46 durchgreifen berührungsfrei Öffnungen 51 der ersten Versteifungeinrichtung 26.

Aus alledem ergibt sich, dass auf Grund der Abstandshalter 30, die vorzugsweise als Distanzhülsen ausgebildet sind, ein definierter Abstand zwischen dem Kontaktabstandstransformer 7 und dem Neigeelement 32 garantiert ist. Die Kontaktabstandsumsetzschaltung 9 ist vorzugsweise unlösbar mit dem Träger 8 verbunden, vorzugsweise verklebt. Insbesondere drücken die vier Einstellschrauben 38 mit ihren Enden 42 gegen die erste Versteifungseinrichtung 26, die auch als Backstiffener bezeichnet wird. Mit Hilfe dieser vier Einstellschrauben 38 kann demzufolge der Abstand zwischen dem Neigeelement 32 und der ersten Versteifungseinrichtung 26 justiert werden. Da die erste Versteifungseinrichtung 26 fest mit dem Leitersubstrat 12 verbunden ist und das Neigeelement 32 eine Fixierung zum Kontaktabstandstransformer 7 aufweist, lässt sich letztendlich mit den Einstellschrauben 38 der Winkel der Referenzfläche 11 des Kontaktabstandstransformers 7 und der Referenzfläche 24 des Leitersubstrats 12 verstellen/einstellen. Nach einer derartigen Einstellung des Winkels zwischen den genannten Referenzflächen 11 und 24 wird der Vorgang durch Anziehen der Feststellschrauben 39 abgeschlossen. Damit sind die zueinander justierten Referenzflächen 11 und 24 fixiert.

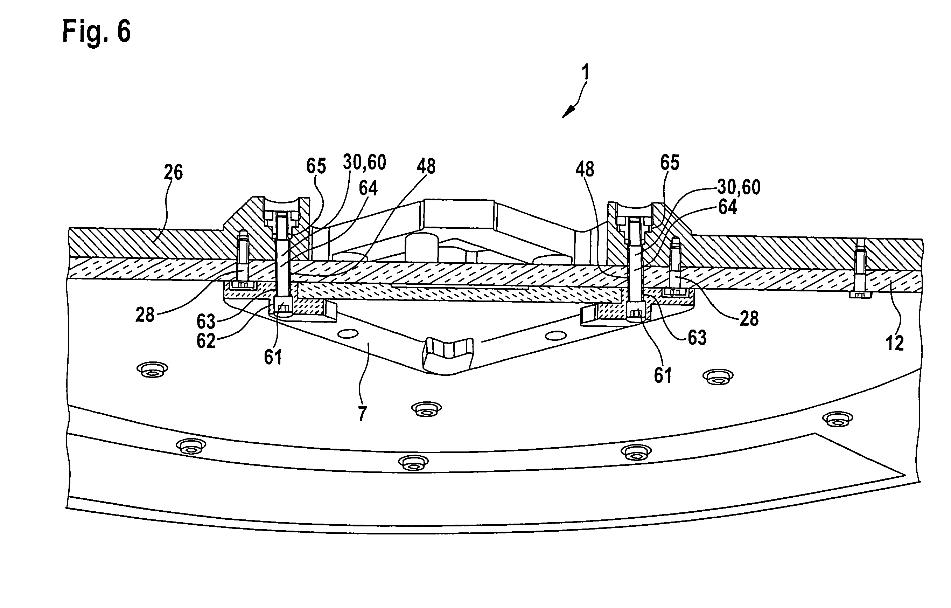

Die Figuren 6 bis 8 betreffen ein weiteres Ausführungsbeispiel einer Prüfeinrichtung. Zu diesem weiteren Ausführungsbeispiel gelten die Ausführungen zum Ausführungsbeispiel der Figuren 1 bis 5 entsprechend, sodass nachstehend nur auf Unterschiede eingegangen wird. Im Gegensatz zum zuvor beschriebenen Ausführungsbeispiel weist das Ausführungsbeispiel der Figuren 6 bis 8 kein Neigeelement auf. Gemäß der Figur 6, die einen Ausschnitt der Prüfeinrichtung 1 nach dem weiteren Ausführungsbeispiel zeigt, wobei die Ansicht der Figur 6 um 180° gedreht ist gegenüber der Ansicht der Figur 2 des anderen Ausführungsbeispiels, ist ersichtlich, dass am Kontaktabstandstransformer 7 mehrere beabstandete Abstandshalter 30 in Form von Gewindeschrauben 60 befestigt sind. Die Gewindeschrauben 60 weisen Köpfe 61 auf, die fest in Aufnahmen 62 des Kontaktabstandstransformers 7 durch Einschrauben der Gewindeschrauben 60 in Gewindebohrungen 63 des Kontaktabstandstransformers 7 einliegen. Die Schäfte 64 der Gewindeschrauben 60 durchgreifen mit Freiraum Führungsöffnungen 48 der Leiterplatte 12 und greifen in Aufnahmen 65 der ersten Versteifungseinrichtung 26 ein.

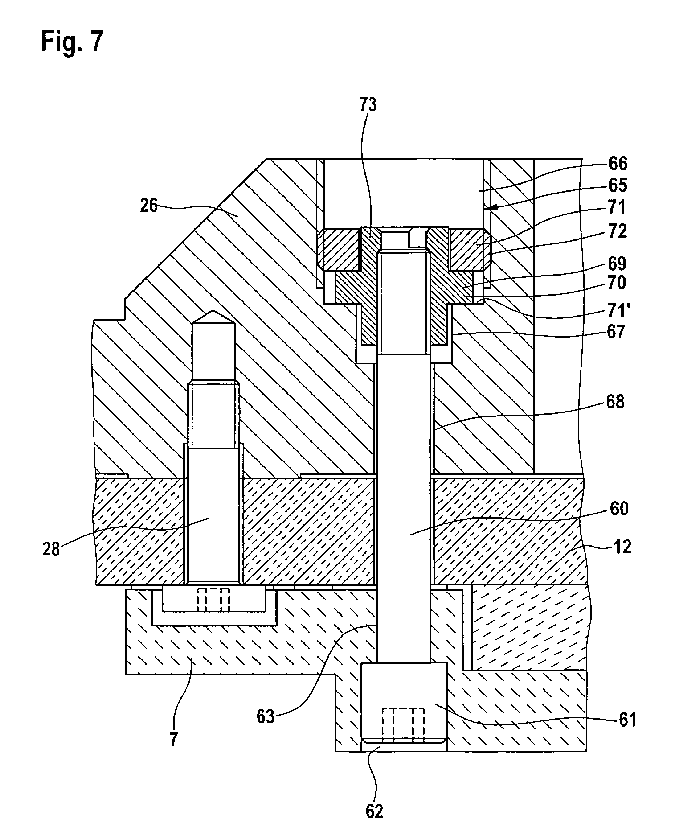

Gemäß Figur 7 weist jede Aufnahme 65 einen mit Innengewinde versehenen, durchmessergroßen Abschnitt 66, einen sich daran anschließenden, im Durchmesser kleineren und gewindefreien Abschnitt 67 und einen im Durchmesser noch kleineren und ebenfalls gewindefreien Abschnitt 68 auf. Der Abschnitt 68 weist Spiel zu dem Schaft 64 der zugehörigen Gewindeschraube 60 auf. Auf das Gewinde der Gewindeschraube 60 ist eine Mutter 69 geschraubt, die sich mit einem Flansch 70 an einer Stufe 71' abstützt. Die Stufe 71' ist zwischen den Abschnitten 66 und 67 ausgebildet. Auf der anderen Seite des Flansches 70 befindet sich ein Schraubring 71, der ein Außengewinde 72 aufweist, das in das Innengewinde des Abschnitts 66 eingeschraubt ist. Das Innere des Schraubringes 71 übergreift einen Stutzen 73 der Mutter 69. Der Schraubring 71 presst im verschraubten Zustand die Mutter 69 gegen die Stufe 71'.

Aus alledem wird deutlich, dass durch entsprechend weites Aufschrauben der jeweiligen Mutter 69 auf die jeweilige Gewindeschraube 60 sich der Kontaktabstandstransformer 7 mit einer entsprechend gewünschten Neigung relativ zum Leitersubstrat 12 einstellen lässt, wobei durch Festschrauben der entsprechenden Schraubringe 71 die jeweilige Mutterposition gesichert wird.

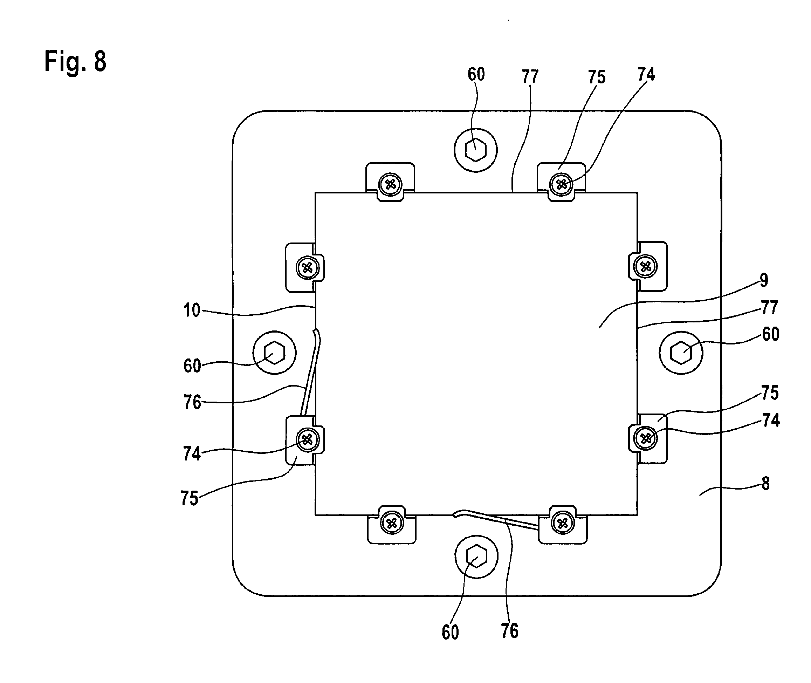

Ferner ist den Figuren 6 und 8 zu entnehmen, dass - anders als beim Ausführungsbeispiel der Figuren 1 bis 5 - die Kontaktabstandsumsetzschaltung 9 nicht in eine Aufnahme 10 eingeklebt ist, sondern in eine Aufnahme 10 des Trägers 8 eingelegt und mittels übergreifender, von Halteschrauben 74 gehaltener Klemmplättchen 75 gehalten ist. Die Klemmplättchen 75 übergreifen die Kontaktabstandsumsetzschaltung 9. Um innerhalb der rechteckförmigen beziehungsweise quadratischen Vertiefung 10 eine reproduzierbare Position der Kontaktabstandsumsetzschaltung 9 einzuhalten, sind Klemmfedern 76 an zwei Seiten der Aufnahme 10 vorgesehen, die die Kontaktabstandsumsetzschaltung 9 an entsprechend gegenüberliegende Kanten 77 der Aufnahme 10 drängen, wodurch eine hochgenaue Positionierung gewährleistet ist.

Diese vorstehende Art der Positionierung der Kontaktabstandsumsetzschaltung 9 kann selbstverständlich auch bei dem Ausführungsbeispiel der Figuren 1 bis 5 vorgesehen sein. Natürlich ist es andererseits auch möglich, dass das Ausführungsbeispiel der Figuren 6 bis 8 eine eingeklebte Kontaktabstandsumsetzschaltung 9 aufweist.

Die Bauhöhe der Prüfeinrichtung 1 des Ausführungsbeispiels der Figuren 6 bis 8 ist aufgrund der fehlenden Neigeplatte kleiner. Auch verbilligt sich diese Ausführungsform, da die Neigeplatte entfallen kann.

## Patentansprüche

1. Elektrische Prüfeinrichtung für die Prüfung eines elektrischen Prüflings, mit einem Leitersubstrat, das über einen Kontaktabstandstransformer mit einem Prüfkopf elektrisch verbunden ist, wobei das Leitersubstrat mit einer ersten Versteifungseinrichtung mechanisch verbunden und **dadurch** versteift ist, **dadurch gekennzeichnet, dass** mindestens ein das Leitersubstrat (12) durchgreifender Abstandshalter (30) mit dem Kontaktabstandstransformer (7) mechanisch verbunden ist und an der ersten Versteifungseinrichtung (26) über Neigungseinstellmittel (34) gehalten ist.

2. Prüfeinrichtung nach Anspruch 1, **gekennzeichnet durch** ein Neigeelement (32), das über den mindestens einen das Leitersubstrat (12) durchgreifenden Abstandshalter (30) mit dem Kontaktabstandstransformer (7) mechanisch verbunden ist und neigungsverstellbar an der ersten Versteifungseinrichtung (26) über die Neigungseinstellmittel (34) gehalten ist.

3. Prüfeinrichtung nach einem der vorhergehenden Ansprüche, **dadurch gekennzeichnet, dass** der Abstandshalter (30) die erste Versteifungseinrichtung (26) durchgreift.

4. Prüfeinrichtung nach einem der vorhergehenden Ansprüche, **dadurch gekennzeichnet, dass** das Leitersubstrat (12) erste Kontaktflächen (14) aufweist, die über Kontaktmittel (18) mit Gegenkontaktflächen (22) des Kontaktabstandstransformers (7) verbunden sind.

5. Prüfeinrichtung nach einem der vorhergehenden Ansprüche, **dadurch gekennzeichnet, dass** die Kontaktmittel (18) einen durch Neigungseinstellung bewirkten Winkelversatz zwischen Leitersubstrat (12) und Kontaktabstandstransformer (7) ausgleichen.

6. Prüfeinrichtung nach einem der vorhergehenden Ansprüche, **dadurch gekennzeichnet, dass** der Kontaktabstandstransformer (7) zweite Kontaktflächen (23) aufweist, die mit Kontaktstiften (4)/Kontaktnadeln, insbesondere Knicknadeln, des Prüfkopfs (2) in elektrischem Kontakt stehen.

7. Prüfeinrichtung nach einem der vorhergehenden Ansprüche, **dadurch gekennzeichnet, dass** am Kontaktabstandstransformer (7) Kontaktelemente zur elektrischen Berührungskontaktierung des Prüflings fest angeordnet sind.

8. Prüfeinrichtung nach einem der vorhergehenden Ansprüche, **dadurch gekennzeichnet, dass** die Kontaktmittel (18) direkt und fest am Kontaktabstandstransformer (7) angeordnet sind.

9. Prüfeinrichtung nach einem der vorhergehenden Ansprüche, **gekennzeichnet durch** eine zweite Versteifungseinrichtung (27), wobei die erste Versteifungseinrichtung (26) auf der einen Seite des Leitersubstrats (12) und die zweite Versteifungseinrichtung (27) auf der anderen Seite des Leitersubstrats (12) angeordnet ist.

10. Prüfeinrichtung nach einem der vorhergehenden Ansprüche, **dadurch gekennzeichnet,** das der zweiten Versteifungseinrichtung (27) der Kontaktabstandstransformer (7) zugeordnet ist.

11. Prüfeinrichtung nach einem der vorhergehenden Ansprüche, **dadurch gekennzeichnet, dass** die zweite Versteifungseinrichtung (27) einen Aufnahmedurchbruch (29) aufweist, in der der Kontaktabstandstransformer (7) berührungsfrei zumindest teilweise aufgenommen ist.

12. Prüfeinrichtung nach einem der vorhergehenden Ansprüche, **dadurch gekennzeichnet, dass** die Neigungseinstellmittel (34) Gewindeschrauben (36) aufweisen.

13. Prüfeinrichtung nach einem der vorhergehenden Ansprüche, **dadurch gekennzeichnet, dass** den Gewindeschrauben Fühlerlehrenbänder zur Neigungseinstellung untergelegt sind.

14. Prüfeinrichtung nach einem der vorhergehenden Ansprüche, **dadurch gekennzeichnet, dass** die Gewindeschrauben (36) als Einstellschrauben (38) und/oder als Feststellschrauben (39) ausgebildet sind.

15. Prüfeinrichtung nach einem der vorhergehenden Ansprüche, **dadurch gekennzeichnet, dass** die Einstellschrauben (38) in das Neigeelement (32) einstellbar eingeschraubt sind und sich mit ihren einen Enden an der ersten Versteifungseinrichtung (26) abstützen.

16. Prüfeinrichtung nach einem der vorhergehenden Ansprüche, **dadurch gekennzeichnet, dass** die Feststellschrauben (39) in die erste Versteifungseinrichtung (26) eingeschraubt sind und mit ihren Köpfen (45) spannend an dem Neigeelement (32) anliegen.

17. Prüfeinrichtung nach einem der vorhergehenden Ansprüche, **dadurch gekennzeichnet, dass** das Neigeelement (32) als Neigeplatte (33) ausgebildet ist.

18. Prüfeinrichtung nach einem der vorhergehenden Ansprüche, **dadurch gekennzeichnet, dass** das Leitersubstrat (12) als Leiterplatte (13) ausgebildet ist.

19. Prüfeinrichtung nach einem der vorhergehenden Ansprüche, **dadurch gekennzeichnet, dass** die erste und/oder die zweite Versteifungseinrichtung (26, 27) plattenförmig ausgebildet ist/sind.

20. Prüfeinrichtung nach einem der vorhergehenden Ansprüche, **dadurch gekennzeichnet, dass** der Abstandshalter (30) eine Distanzhülse aufweist.

21. Prüfeinrichtung nach einem der vorhergehenden Ansprüche, **dadurch gekennzeichnet, dass** Ausrichtmittel (46) vorhanden sind, die das Leitersubstrat (12) zu dem Kontaktabstandstransformer (7) seitwärts ausrichten.

22. Prüfeinrichtung nach einem der vorhergehenden Ansprüche, **dadurch gekennzeichnet, dass** die Neigungseinstellmittel (34) an dem Abstandshalter (30) angeordnet sind.

23. Prüfeinrichtung nach einem der vorhergehenden Ansprüche, **dadurch gekennzeichnet, dass** mehrere Abstandshalter (30) mit Abstand zueinander vorgesehen sind.

24. Verfahren für die elektrische Prüfung eines elektrischen Prüflings, insbesondere mit Verwendung einer Prüfeinrichtung nach einem oder mehreren der vorhergehenden Ansprüche, mit einem Leitersubstrat (12), das über einen Kontaktabstandstransformer (7) mit einem Prüfkopf elektrisch verbunden wird, wobei das Leitersubstrat (12) mit einer ersten Versteifungseinrichtung (26) mechanisch verbunden und **dadurch** versteift wird, **dadurch gekennzeichnet, dass** mindestens ein das Leitersubstrat (12) durchgreifenden Abstandshalter (30) mit dem Kontaktabstandstransformer (7) mechanisch verbunden wird und an der ersten Versteifungseinrichtung (26) über Neigungseinstellmittel (34) gehalten wird.

25. Verfahren nach Anspruch 24, **dadurch gekennzeichnet, dass** der Abstandshalter (30) die erste Versteifungseinrichtung (26) durchgreift.
